# EUROPÄISCHE PATENTSCHRIFT

(11) **EP 1 994 573 B1**
(45) Veröffentlichungstag und Bekanntmachung des Hinweises auf die Patenterteilung: **03.10.2012**
(21) Anmeldenummer: 07722052.3
(22) Anmeldetag: 16.03.2007
(51) Int. Cl.: H01L 41/047, H01L 41/083

(54) **ELEKTRISCHES VIELSCHICHTBAUELEMENT**
ELECTRICAL MULTILAYER COMPONENT
COMPOSANT ÉLECTRIQUE MULTICOUCHE

(30) Priorität: 16.03.2006 DE 102006012182; 05.07.2006 DE 102006031085; 31.07.2006 DE 102006035634
(43) Veröffentlichungstag der Anmeldung: 26.11.2008
(73) Patentinhaber: EPCOS AG, 81669 München (DE)
(72) Erfinder: HIRSCHLER, Michael, A-8020 Graz (AT); SOMMARIVA, Helmut, A-8053 Graz (AT); STIMPFL, Peter, A-8053 Graz (AT)
(74) Vertreter: Epping - Hermann - Fischer
(86) Internationale Anmeldenummer: PCT/DE2007/000488
(87) Internationale Veröffentlichungsnummer: WO 2007/104301

(56) Entgegenhaltungen:
- WO-A-98/05080
- WO-A-2005/034255
- WO-A-2006/000479
- WO-A-2006/103154
- DE-A1-102004 031 404
- US-B1- 6 366 444

## Beschreibung

Es wird ein elektrisches Vielschichtbauelement mit einer die Propagation von Druckwellen hemmenden Elektrodenschicht beschrieben.

Aus der Druckschrift WO 2004/077583 A1 ist ein elektrisches Vielschichtbauelement bekannt, in dem eine keramische Sollbruchschicht angeordnet ist.

In den Druckschriften WO 2006/000479 A1 und DE 10 2004 031 404 A1 sind jeweils piezoelektrische Bauelemente beschrieben, die Sollbruchstellen aufweisen, wobei die Erzeugung einer Sollbruchstelle beispielsweise durch die chemische Zusammensetzung und/oder die Materialstruktur zumindest einer Elektrodenschicht, beispielsweise durch die Porosität, erreicht werden kann.

Eine zu lösende Aufgabe besteht darin, ein alternatives elektrisches Vielschichtbauelement zu schaffen, das gegen mechanische Belastungen möglichst unempfindlich ist.

Es wird ein elektrisches, vorzugsweise ein piezoelektrisches Vielschichtbauelement mit mehreren keramischen Schichten und Elektrodenschichten angegeben, wobei mindestens eine Elektrodenschicht ein gegenüber den keramischen Schichten anderes Materialgefüge aufweist. Die Propagation von auf das Vielschichtbauelement einwirkenden Druckwellen wird mittels der Elektrodenschicht, insbesondere mittels ihres geänderten Materialgefüges, gehemmt. Insbesondere wird die Propagation von Druckwellen in Längsrichtung des Vielschichtbauelements, d.h., senkrecht zu den Elektrodenschichten, gehemmt.

Mit dem Begriff Materialgefüge wird insbesondere die räumliche Struktur, beispielsweise die Korn- bzw. Kristallstruktur sowie die von Zwischenräumen zwischen Festkörpern innerhalb der Elektrodenschicht verstanden, wobei das Materialgefüge dabei nicht den Einsatz von bestimmten, insbesondere keramischen Materialien voraussetzt.

Gemäß einer Ausführungsform des Vielschichtbauelements bewirkt die Elektrodenschicht gegenüber den Druckwellen einen Grenzflächeneffekt, der die Propagation der Druckwellen hemmt. Mit einem Grenzflächeneffekt wird das Verhalten einer Druckwelle verstanden, wenn sie von einem Medium erster Dichte in ein Medium zweiter Dichte eintritt. Dabei werden die Eigenschaften der Druckwelle verändert, wie z.B. ihre Form und / oder ihre Propagationsart. Die Veränderung der Welleneigenschaften könnte durch eine Amplitudenveränderung, Ablenkung, Verzerrung oder Brechung gezeigt werden.

Die Druckwelle kann von Aufprall-, Schlag-, Schwingungsenergie oder andere auf das Vielschichtbauelement einwirkende mechanische Energie stammen.

Der propagationshemmende Effekt kann sowohl innerhalb der Elektrodenschicht entstehen, als auch an der Grenzfläche zwischen der Elektrodenschicht und einer benachbarten keramischen bzw. piezoelektrischen Schicht.

Insbesondere bewirkt die Elektrodenschicht eine Absorption, Brechung, Zerstreuung, Ablenkung oder Dämpfung auf die Druckwellen bzw. die einwirkende mechanische Energie.

Gemäß einer Ausführungsform bewirkt insbesondere der Grenzflächeneffekt in oder bei den Elektrodenschichten eine Absorption, Brechung, Zerstreuung, Dämpfung oder auch Ablenkung der Druckwellen.

Gemäß einer Ausführungsform weist das Vielschichtbauelement mehrere keramischen Schichten und Elektrodenschichten auf, wobei mindestens eine Elektrodenschicht eine Absorptionsfunktion umfasst. Diese Elektrodenschicht kann dabei eine geringere mechanische Stabilität, eine andere Dichte und / oder eine andere Komprimierbarkeit bzw. Elastizität aufweisen als umliegende keramischen Schichten. Die Elektrodenschicht kann dabei neben anderen beschriebenen Effekten überwiegend oder gänzlich eine Absorptionsfunktion gegen die Propagation von mechanischer Energie bzw. Druckwellen durch das Vielschichtbauelement umfassen.

Es wird außerdem ein elektrisches, insbesondere piezoelektrisches Vielschichtbauelement angegeben, das mehrere keramischen Schichten und Elektrodenschichten aufweist, wobei mindestens eine Elektrodenschicht ein gegenüber den keramischen Schichten verändertes Materialgefüge aufweist, das die mechanische Zugfestigkeit der Elektrodenschicht unter die der umgebenden Keramik absenkt. Dabei kann der Bereich verringerter Zugfestigkeit als ein eine Sollbruchfunktion umfassender Bereich der Elektrodenschicht ausgeführt sein bzw. eine Sollbruchstelle aufweisen, wobei die Sollbruchstelle ab einer bestimmten Zugbelastung einen kontrollierten, im Wesentlichen parallel zu den Elektrodenschichten laufenden Riss bildet.

Gemäß einer Ausführungsform der Elektrodenschicht mit abgesenkter Zugfestigkeit enthält.die Elektrodenschicht ein keramisches Material, welche die Zugfestigkeit der Elektrodenschicht gegenüber den umliegenden keramischen Schichten absenkt.

Alternativ oder ergänzend hierzu enthält die Elektrodenschicht gemäß einer Ausführungsform ein keramisches Material, das die mechanische Zugfestigkeit der Grenzfläche zwischen der Elektrodenschicht und der umliegenden Keramik unter die der umliegenden Keramik absenkt. Dabei kann es sich ebenfalls um eine Sollbruchfunktion bzw. eine Sollbruchstelle der Elektrodenschicht handeln.

Abgesehen vom Einsatz eines bestimmten keramischen Materials zur Senkung der Zugfestigkeit der Elektrodenschicht kann diese ein Materialgefüge derart aufweisen, dass sich in der Elektrodenschicht bei mechanischer Belastung ein im Wesentlichen parallel zur Elektrodenschicht verlaufender Riss ausbreitet.

Insbesondere wurde nämlich erkannt, das piezoelektrische Vielschichtaktoren besonders empfindlich sind gegenüber der Zufuhr mechanischer Energie in der Form von Aufprall-, Schall- und Schwingungsenergie, und dass dabei die piezoelektrische Vielschichtaktoren bei Überdehnung zu einer bauteilzerstörenden, unkontrollierten Rissbildung neigen. Es wurde jedoch auch beobachtet, dass diese Rissbildung keinen negativen Einfluss auf die Eigenschaften und Lebensdauer des Vielschichtbauelements hat, wenn sie parallel zu den Elektroden verläuft.

Das vorgeschlagene elektrische Vielschichtbauelement hat nun den Vorteil, dass durch eine mit bzw. an der Elektrodenschicht geschaffene Sollbruchstelle eine Rissbildung innerhalb der Elektrodenschicht im Wesentlichen parallel zu den Ebenen der Elektrodenschichten bzw. den keramischen Schichten erfolgt. Es ist jedoch auch möglich, dass aufgrund einer zumindest teilweisen Absorption der mechanischen Energie durch die Elektrodenschichten das elektrische Vielschichtbauelement unter mechanischer Belastung gänzlich rissfrei bleibt.

Die Elektrodenschicht umfasst gemäß einer Ausführungsform sowohl eine Absorptionsfunktion als auch eine Sollbruchfunktion. Dabei hemmt die Elektrodenschicht Druckwellen bis zu einer bestimmten Intensität in dem sie sie zumindest teilweise absorbiert, wirkt jedoch als Sollbruchstelle wenn die Intensität überstiegen wird. Die bestimmte Intensität richtet sich dabei an die Betriebsumstände des Vielschichtbauelements; hängt beispielsweise also von der Betriebstemperatur, der Zeit der Belastung bzw. der Dauerbelastung des Vielschichtbauelements sowie von der Frequenz der Beaufschlagung mit einem elektrischen Feld ab.

Durch die hier beschriebene Elektrodenschicht mit geändertem Materialgefüge bzw. umfassend eine Absorptionsschicht und /oder eine Sollbruchstelle kann das Vielschichtbauelement auch bei höherem Energieeintrag länger verwendet werden. Das hat auch den Vorteil, dass das Vielschichtbauelement bei einem es einsetzenden Gerät, beispielsweise eine Einspritzvorrichtung, wenn es sich um ein piezoelektrisches Vielschichtbauelement handelt, weniger häufig ausgetauscht werden muss bzw. die Verwendbarkeit des betroffenen Geräts sich verlängert. Es können hiermit unter anderem auch aufwendige und teuere Wartungsarbeiten eingespart werden.

Elektrodenschichten eines hier beschriebenen Vielschichtbauelements haben die Funktion von Innenelektroden und dienen dem Aufbau eines elektrischen Feldes in den keramischen Schichten, die den Elektrodenschichten benachbart sind. Somit weisen sie vorteilhafterweise sowohl eine elektrische, feldaufbauende Funktion als auch eine mechanische Stabilitätsfunktion für das Vielschichtbauelement auf, wodurch die räumlichen Abmessungen des Bauelements möglichst klein gehalten werden können.

Gemäß einer Ausführungsform des elektrischen Vielschichtbauelements kann die Elektrodenschicht als Bereich mit veränderter Dichte und somit Elastizität beziehungsweise Komprimierbarkeit im Vielschichtbauelement konzipiert sein. Dieser Bereich soll Druck- bzw. Schallwellen ablenken und Vibrationsenergie aufnehmen. Dabei könnte die Elektrodenschicht eine geringere Dichte und/oder eine höhere Komprimierbarkeit aufweisen, als umliegende keramische Schichten.

Eine ganz, überwiegend, zumindest teilweise oder vorübergehend als Absorptionsschicht wirkende Elektrodenschicht hat den Vorteil, dass bei einer schnellen Abfolge mehrerer mechanischer Stöße auf das Vielschichtbauelement eine dauerhafte Ausbreitung der dadurch entstehenden mechanischen Stoßwellen, beispielsweise auch durch Reflexion an den äußeren Enden des Bauelements, wirksam vermindert werden kann. Hierfür wird die Elektrodenschicht so gestaltet, dass beispielsweise in Schallgeschwindigkeit durch das Bauelement laufende Stoßwellen an Grenzflächen zwischen einer Elektrodenschicht und einer anderen Schicht, beispielsweise einer keramischen Schicht, eine Beugung oder eine Brechung erfahren, wodurch die geradlinige Ausbreitung der Stoßwelle geschwächt wird. Dadurch können sich hochschaukelnde bzw. kumulierende, durch schnelle aufeinander folgende mechanische Stöße bewirkte Stoßwellenpakete hinsichtlich ihrer Intensität verringert und die Gefahr der Zerstörung des Vielschichtbauelements vermindert werden.

Das elektrische Vielschichtbauelement ist vorzugsweise ein piezoelektrischer Vielschichtaktor, dessen Keramik eine Piezokeramik enthält, vorzugsweise eine PZT-Keramik.

Zur Herstellung des elektrischen Vielschichtbauelements sind vorteilhafterweise keine weiteren Schritte erforderlich, als solche, die für die Herstellung eines keine Elektrodenschicht mit zusätzlicher Funktion aufweisenden elektrischen Vielschichtbauelements nötig sind. Das wird dadurch erreicht, dass beispielsweise keine zusätzliche, von der Elektrodenschicht und den keramischen Schichten getrennte Schicht geschaffen werden muss, die veränderte Abmessungen, insbesondere vergrößerte Abmessungen des elektrischen Vielschichtbauelements zur Folge hätte. Die Elektrodenschicht wird samt ihrer das Vielschichtbauelement vor mechanischen Belastungen schützenden Eigenschaft in einem und demselben Prozessschritt hergestellt.

Nach einer Ausführungsform des elektrischen Vielschichtbauelements enthält mindestens eine Elektrodenschicht einen Zusatz eines Materials, das die mechanische Zugfestigkeit der Elektrodenschicht gegenüber den keramischen schichten absenkt. Es ist günstig, wenn es sich dabei um keramische Zusätze handelt. Die keramischen Zusätze können dabei das gleiche Material enthalten, wie die keramischen Schichten. Andere Materialien, die den genannten Effekt haben, können jedoch ebenfalls eingesetzt werden.

Der keramische Zusatz ist vorzugsweise derart beschaffen, dass er das Materialgefüge der Elektrodenschicht soweit schwächt, dass die mechanische Zugfestigkeit geringer ist als die der umgebenden Keramik.

Der keramische Zusatz kann zusätzlich oder alternativ die Dichte oder die Komprimierbarkeit der Elektrodenschicht soweit verändern, dass diese als Absorptionsschicht wirkt. Der keramische Zusatz kann bei der Herstellung des elektrischen Vielschichtbauelements in demselben Herstellungsschritt wie in dem der Elektrodenschicht beigemengt werden, sodass vorteilhafterweise kein weiterer Herstellungsschritt notwendig ist.

Gemäß einer Ausführungsform des elektrischen Vielschichtbauelements ist den Elektrodenschichten keramisches Material zugesetzt, das vorzugsweise Keramikkörner, deren Größen sich um das Vielfache voneinander unterscheiden aufweist. Dabei wird vorzugsweise eine Mischung aus im Vergleich zu umliegenden Keramikschichten lediglich groben oder aus groben und feinen Körnern gewählt.

Die mechanische Zugfestigkeit im Bereich bzw. innerhalb einer Elektrodenschicht kann aufgrund der Diffusion von Material während des Sinterns des Vielschichtbauelements gleich oder größer sein als die der umliegenden Keramik. Diese Festigkeit könnte durch den Zusatz feinvermahlener Keramik sogar noch erhöht werden, um an benötigter Menge an relativ teurem Elektrodenmaterial zu sparen bzw. oder die Verwendung von niedriger schmelzenden Legierungen als Elektrodenschicht zu begünstigen.

Es wird dennoch vorgeschlagen, durch einen Zusatz einer groben Keramik oder einer Keramik die sich von jener der keramischen Schichten unterscheidet eine für eine Sollbruchstelle bzw. Absorptionsschicht günstige Festigkeit- oder Dichte zu erreichen. Der Zusatz schließt jedoch nicht den gleichzeitigen Einsatz von feinvermahlener Keramik zu dem genannten Zweck aus und zerstört auch nicht die zur Funktion der Elektrodenschicht nötige elektrische Leitfähigkeit.

Gemäß einer Ausführungsform des elektrischen Vielschichtbauelements umfassen die keramischen Zusätze Mischungen aus Zirkonoxid und Titanoxid. Grundsätzlich sind jedoch andere keramische Zusätze einsetzbar, die ein gegenüber der umgebenen Keramik verändertes Materialgefüge bilden. Die Mischungen weisen erfindungsgemäß Fein- und Grobkörner in ausgewählten Anteilen in einer bimodalen Korngrößenverteilung auf. Eine solche bimodale Korngrößenverteilung des keramischen Zusatzes ermöglicht dabei die Bildung der Elektrode der Elektrodenschicht durch die Wirkung des Feinkorns mit verringertem Metallbedarf und/oder verändertem Legierungsverhältnis, beispielsweise eine Legierung mit einem verringerten Anteil von Palladium, aber auch gleichzeitig die Bildung einer mechanisch abgeschwächten bzw. einer der Propagation von Druckwellen hemmenden Stelle, beispielsweise zum Bilden einer Sollbruchstelle, durch die Anwesenheit des Grobkorns- oder Fremdkorns.

Wenn eine Sollbruchstelle einer Elektrodenschicht derart belastet wird, dass sie Risse bildet, ist durch die keramischen Zusätze schlimmstenfalls das Bilden von Rissen ersten Grades möglich, wobei Risse ersten Grades ihrerseits die Entstehung von Rissen zweiten Grades verhindern.

Ein Riss ersten Grades ist dabei derart zu verstehen, dass er nicht oder nur äußerst geringfügig die Funktionstüchtigkeit des elektrischen Vielschichtbauelements beeinträchtigt. Er verläuft dabei im Wesentlichen parallel zu einer Elektrodenschicht.

Ein Riss zweiten Grades ist dabei einer, der direkt zum Ausfall des Bauelements führen kann, beispielsweise dadurch, dass er durch Spaltung eines Dielektrikums bzw. keramischen Schicht einen elektrischen Pfad schafft, der seinerseits einen Kurzschluss zwischen unterschiedlichen elektrischen Polen bzw. unterschiedlich gepolten Elektrodenschichten des Bauelements verursachen könnte. Risse zweiten Grades könnten beispielsweise senkrecht zu den Ebenen der keramischen- und Elektrodenschichten verlaufen. Sie werden durch die Entstehung von Rissen ersten Grades vermieden, indem durch die Risse ersten Grades kleinere Bruchstücke in der Elektrodenschicht entstehen und somit mechanische Spannungen innerhalb dieser Schicht derart abgebaut werden, dass auch unter weiterer mechanischer Belastung keine weiteren Risse entstehen können.

Das elektrische Vielschichtbauelement ist vorzugsweise mit Zuleitungen oder an seiner Oberfläche mit Außenkontakten versehen, die die Elektrodenschichten kontaktieren.

Das elektrische Vielschichtbauelement kann durch seine erhöhte mechanische Stabilität in Geräten verwendet werden, die mechanischen Schwingungen ausgesetzt sein können, wie beispielsweise Motoren oder Triebwerke. Dabei kommen insbesondere Benzin-, Kerosin- oder Dieselmotoren für Kraftfahr- bzw. Flugzeuge oder Züge in Betracht.

Auch wird eine Einspritzvorrichtung angegeben, welche das piezoelektrische Vielschichtbauelement aufweist. Dabei könnte das piezoelektrische Vielschichtbauelement an einer Stirnseite mechanisch mit einem Ventil bzw. mit einer Ventilnadel verbunden und an der anderen Stirnseite fest oder nahezu fest gelagert sein.

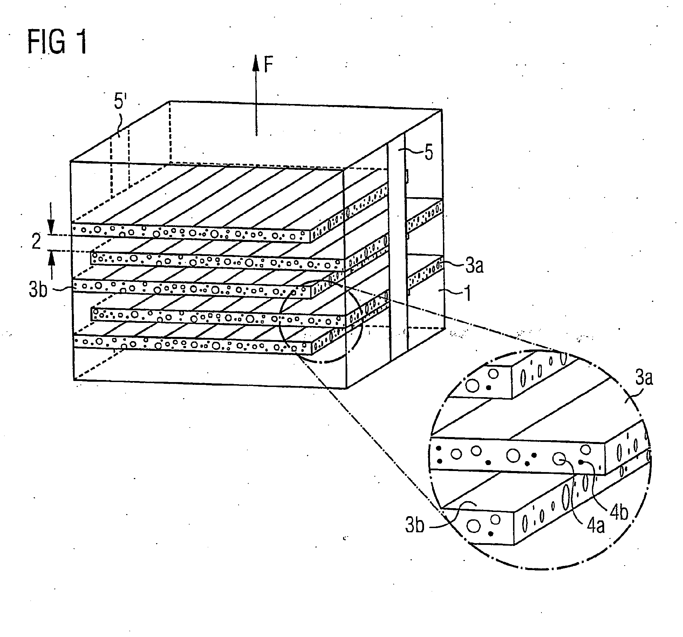

Die beschriebenen Gegenstände werden anhand der folgenden Figur und Ausführungsbeispielen näher erläutert. Dabei zeigt: Figur 1 ein elektrisches Vielschichtbauelement mit Elektrodenschichten, die einen keramischen Zusatz enthalten.

Figur 1 zeigt ein elektrisches Vielschichtbauelement 1, das eine Vielzahl von übereinanderliegenden Keramikschichten 2 aufweist. Die Keramikschichten sind entlang einer Längsachse, die mit einem Pfeil dargestellt ist, angeordnet. Zwischen den keramischen Schichten sind Elektrodenschichten 3a, 3b angeordnet. In zumindest einer Elektrodenschicht 3a oder 3b befindet sich ein die Propagation in Längsrichtung des Vielschichtbauelements von Druckwellen hemmender Bereich. Das wird hier durch die Präsenz von keramischen Zusätzen in der Elektrodenschicht ermöglicht.

Die Elektrodenschichten 3a und 3b enthalten einen bestimmten keramischen Zusatz, der sowohl aus groben 4a als auch aus feinen 4b keramischen Körnern besteht.

Die Elektrodenschichten 3a gehören zu einem elektrischen Pol des Vielschichtbauelements und die Elektrodenschichten 3b zum anderen Pol des Bauelements. Die bis ganz an den rechten Rand des Bauelements herangeführten Elektrodenschichten 3a sind durch die Außenkontaktierung 5 miteinander elektrisch leitend verbunden.

Dementsprechend sind die auf der linken Seite des Bauelements bis an den äußeren Rand reichenden Elektrodenschichten 3b mit einer auf der linken Seite des Bauelements angeordneten Außenkontaktierung 5' elektrisch leitend verbunden.

Vorzugsweise wird das Bauelement 1 durch Sintern eines Stapels von übereinanderliegenden keramischen Grünfolien und dazwischenliegenden Elektrodenschichten hergestellt. Dadurch entsteht ein monolithisches Vielschichtbauelement.

Um die maximale Belastung des Bauelements durch die mechanischen Schwingungen weiter zu reduzieren, kann es vorgesehen sein, daß an mehreren Stellen der Längsachse druckwellenhemmende bzw. als Sollbruchschichten wirkende Elektrodenschichten, die jeweils keramische Zusätze enthalten können, vorgesehen sind. Diese sind derart beschaffen, dass sie bei mechanischen Belastungen lediglich Risse ersten Grades bilden.

Mit den solchen Elektrodenschichten wird das Bauelement in mehrere Teil-Bauelemente unterteilt, wobei jedes Teil-Bauelement hinsichtlich der Belastung durch die mechanischen Spannungen separat betrachtet werden kann. Es können sich nicht mehr über die gesamte Länge des piezoelektrischen Vielschichtbauelements mechanische Schwingungen oder Zugspannungen aufaddieren und somit zu unkontrollierten Rissen im Bauelement führen.

Wenn das elektrische Vielschichtbauelement n Elektrodenschichten der beschriebenen Art 3a, 3b aufweist, würde es in k Bereiche aufgeteilt werden in denen sich jeweils mechanische Spannungen aufbauen können, wobei k > n - 1 ist. Die k Bereiche entsprechen die neben einer Elektrodenschicht befindlichenkeramischen Schichten 2. Jeder dieser Bereiche ist jedoch so schmal bzw. klein, dass pro Bereich lediglich kleine mechanische Spannungen entstehen können, die sofort an einer benachbarten Elektrodenschicht mittels ihres Grenzflächeneffekts bzw. ihrer Absorptionswirkung oder in dem Falle, dass es sich bei der Elektrodenschicht um eine Sollbruchschicht handelt, mittels eines mechanischen Bruchs abgebaut werden können.

Die Verteilung der Elektrodenschichten 3a und 3b kann also entlang der Längsachse des Vielschichtbauelements derart gleichmäßig gewählt werden, daß Teil-Bauelemente entstehen, deren Höhe so stark reduziert ist, daß die bei dem normalen Betrieb bzw. beim Polen des Piezoaktors auftretenden Zugspannungen keine Risse außerhalb der Sollbruchstellen oder Absorptionsschichten mehr in dem Bauelement erzeugen können.

Sollte das Vielschichtbauelement zudem mehrere Elektrodenschichten 3a, 3b der genannten Art aufweisen, sodass dadurch mehrere piezoelektrische Vielschichtbauelementteile gebildet werden, könnte bei einer Höhe des piezoelektrischen Vielschichtbauelements von 30 mm dieses durch 9 Elektrodenschichten mit Sollbruchstellen in 10 Teile unterteilt werden, wobei jeder Teil eine Höhe von 3 mm aufweist.

Die Elektrodenschichten 3a, 3b können Silber, Palladium oder Kupfer sowie eine Legierung mehrerer dieser Materialien enthalten.

### Bezugszeichenliste

- 1: elektrisches Vielschichtbauelement
- 2: keramische Schicht
- 3a,3b: Elektrodenschicht
- 4a: grober keramischer Korn
- 4b: feiner keramischer Korn
- 5: erste Außenkontaktierung
- 5': zweite Außenkontaktierung

## Patentansprüche

1. Piezoelektrisches Vielschichtbauelement (1) mit mehreren keramischen Schichten (2) und Elektrodenschichten (3a, 3b), wobei mindestens eine Elektrodenschicht ein gegenüber den keramischen Schichten verändertes Materialgefüge aufweist, welches die mechanische Zugfestigkeit der Elektrode unter die der umgebenden Keramik absenkt, wobei die mindestens eine Elektrodenschicht eine Mischung aus groben (4a) und feinen keramischen Körnern (4b) in einer bimodalen Korngrößenverteilung enthält.

2. Piezoelektrisches Vielschichtbauelement (1) nach Anspruch 1, bei dem die Elektrodenschicht (3a, 3b) ein keramisches Material enthält, welches die mechanische Zugfestigkeit der Elektrode unter die der umgebenden Keramik absenkt.

3. Piezoelektrisches Vielschichtbauelement (1) nach einem der Ansprüche 1 oder 2, bei dem mindestens eine Elektrodenschicht (3a, 3b) keramisches Material enthält, das die mechanische Zugfestigkeit der Grenzfläche Elektrode - Keramik unter die der umgebenden Keramik absenkt.

4. Piezoelektrisches Vielschichtbauelement (1) nach einem der vorhergehenden Ansprüche, bei dem die Elektrodenschicht (3a, 3b) bei mechanischen Belastungen als Sollbruchstelle wirkt.

5. Piezoelektrisches Vielschichtbauelement nach einem der vorhergehenden Ansprüche, bei dem sich unter mechanischer Belastung in der Elektrodenschicht (3a, 3b) ein im Wesentlichen parallel zur Elektrodenschicht kontrolliert verlaufender Riss ausbreitet.

6. Piezoelektrisches Vielschichtbauelement nach einem der Ansprüche 2 bis 5, bei dem das in der Elektrodenschicht (3a, 3b) enthaltene keramische Material sich vom keramischen Material umliegender keramischer Schichten (2) unterscheidet.

7. Piezoelektrisches Vielschichtbauelement nach einem der vorhergehenden Ansprüche, bei dem die Elektrodenschicht (3a, 3b) keramisches Material in einer Mischung aus Zirkonoxid und Titanoxid enthält.

8. Piezoelektrisches Vielschichtbauelement nach einem der vorhergehenden Ansprüche, bei dem die Elektrodenschicht (3a, 3b) zumindest ein Metall enthält, das gewählt ist aus: Palladium, Silber, Kupfer.

9. Piezoelektrisches Vielschichtbauelement (1) nach einem der vorhergehenden Ansprüche, bei dem die keramischen Schichten (2) eine Mischung aus Blei, Zirkonat und Titanat enthalten.

10. Piezoelektrisches Vielschichtbauelement (1) nach einem der vorhergehenden Ansprüche, bei dem sich die Größen der groben und der feinen keramischen Körner um ein Mehrfaches unterscheiden.

11. Piezoelektrisches Vielschichtbauelement (1) nach einem der vorhergehenden Ansprüche, bei dem die Verteilung der Elektrodenschichten (3a, 3b) regelmäßige Abstände zueinander umfasst, wobei die jeweiligen Abstände durch mehrere keramische Schichten (2) gebildet sind.

12. Piezoelektrisches Vielschichtbauelement (1) nach einem der vorhergehenden Ansprüche, bei dem mindestens eine Elektrodenschicht (3a, 3b) keramisches Material enthält, das die Dichte soweit gegenüber der umgebenden Keramik verändert, dass auf das Vielschichtbauelement einwirkende Druckwellen absorbiert, gebrochen, umgelenkt oder zerstreut werden.

13. Piezoelektrisches Vielschichtbauelement nach einem der vorhergehenden Ansprüche, bei dem mindestens eine Elektrodenschicht (3a, 3b) keramisches Material enthält, das die Komprimierbarkeit soweit gegenüber der umgebenden Keramik verändert, dass auf das Vielschichtbauelement einwirkende Druckwellen absorbiert, gebrochen, umgelenkt oder zerstreut werden.

14. Piezoelektrisches Vielschichtbauelement (1) nach einem der vorhergehenden Ansprüche, bei dem die Elektrodenschichten (3a, 3b) abwechselnd gestapelt und mit unterschiedlichen Außenanschlüssen (5) kontaktiert sind.

15. Piezoelektrisches Vielschichtbauelement (1) mit mehreren keramischen Schichten (2) und Elektrodenschichten (3a, 3b), wobei mindestens eine Elektrodenschicht ein gegenüber den keramischen Schichten verändertes Materialgefüge aufweist, welches die Propagation in Längsrichtung von auf das Vielschichtbauelement einwirkenden Druckwellen zumindest teilweise hemmt, wobei die mindestens eine Elektrodenschicht eine Mischung aus groben (4a) und feinen keramischen Körnern (4b) in einer bimodalen Korngrößenverteilung enthält.

## Claims

1. Piezoelectric multilayer component (1) having a plurality of ceramic layers (2) and electrode layers (3a, 3b), wherein at least one electrode layer has a material microstructure which is modified relative to the ceramic layers and which lowers the mechanical tensile strength of the electrode below that of the surrounding ceramic, wherein the at least one electrode layer contains a mixture of coarse ceramic grains (4a) and fine ceramic grains (4b) in a bimodal grain size distribution.

2. Piezoelectric multilayer component (1) according to Claim 1, wherein the electrode layer (3a, 3b) contains a ceramic material which lowers the mechanical tensile strength of the electrode below that of the surrounding ceramic.

3. Piezoelectric multilayer component (1) according to either of Claims 1 and 2, wherein at least one electrode layer (3a, 3b) contains ceramic material which lowers the mechanical tensile strength of the electrode-ceramic interface below that of the surrounding ceramic.

4. Piezoelectric multilayer component (1) according to one of the preceding claims, wherein the electrode layer (3a, 3b) acts as a predetermined breaking point under mechanical stresses.

5. Piezoelectric multilayer component according to one of the preceding claims, wherein a crack which runs in a controlled manner substantially parallel to the electrode layer propagates under mechanical loading in the electrode layer (3a, 3b).

6. Piezoelectric multilayer component according to one of Claims 2 to 5, wherein the ceramic material present in the electrode layer (3a, 3b) differs from the ceramic material of surrounding ceramic layers (2).

7. Piezoelectric multilayer component according to one of the preceding claims, wherein the electrode layer (3a, 3b) contains ceramic material in a mixture of zirconium oxide and titanium oxide.

8. Piezoelectric multilayer component according to one of the preceding claims, wherein the electrode layer (3a, 3b) contains at least one metal selected from the group consisting of: palladium, silver, copper.

9. Piezoelectric multilayer component (1) according to one of the preceding claims, wherein the ceramic layers (2) contain a mixture of lead, zirconate and titanate.

10. Piezoelectric multilayer component (1) according to one of the preceding claims, wherein the sizes of the coarse ceramic grains and of the fine ceramic grains differ by a multiple.

11. Piezoelectric multilayer component (1) according to one of the preceding claims, wherein the distribution of the electrode layers (3a, 3b) comprises regular spacings relative to one another, wherein the respective spacings are formed by a plurality of ceramic layers (2).

12. Piezoelectric multilayer component (1) according to one of the preceding claims, wherein at least one electrode layer (3a, 3b) contains ceramic material which changes the density relative to the surrounding ceramic to the extent that pressure waves acting on the multilayer component are absorbed, refracted, deflected or diffused.

13. Piezoelectric multilayer component according to one of the preceding claims, wherein at least one electrode layer (3a, 3b) contains ceramic material which changes the compressibility relative to the surrounding ceramic to the extent that pressure waves acting on the multilayer component are absorbed, refracted, deflected or diffused.

14. Piezoelectric multilayer component (1) according to one of the preceding claims, wherein the electrode layers (3a, 3b) are stacked in an alternating configuration and are contacted with different external connections (5).

15. Piezoelectric multilayer component (1) having a plurality of ceramic layers (2) and electrode layers (3a, 3b), wherein at least one electrode layer has a material microstructure which is modified relative to the ceramic layers and which at least partially blocks the propagation, in the longitudinal direction, of pressure waves acting on the multilayer component, wherein the at least one electrode layer contains a mixture of coarse ceramic grains (4a) and fine ceramic grains (4b) in a bimodal grain size distribution.

## Revendications

1. Composant piézoélectrique multicouche (1) présentant plusieurs couches céramiques (2) et plusieurs couches d'électrode (3a, 3b),
le matériau d'au moins une couche d'électrode présentant un réseau différent de celui des couches céramiques et qui abaisse la résistance mécanique en traction de l'électrode en dessous de celle de la céramique qui l'englobe,
la ou les couches d'électrode contenant un mélange de grains céramiques grossiers (4a) et de grains céramiques fins (4b) dans une répartition granulométrique bimodale.

2. Composant piézoélectrique multicouche (1) selon la revendication 1, dans lequel la couche d'électrode (3a, 3b) contient un matériau céramique qui abaisse la résistance mécanique en traction de l'électrode en dessous de celle de la céramique qui l'englobe.

3. Composant piézoélectrique multicouche (1) selon l'une des revendications 1 ou 2, dans lequel au moins une couche d'électrode (3a, 3b) contient un matériau céramique qui abaisse la résistance mécanique en traction de la surface frontière entre l'électrode et la céramique en dessous de celle de la céramique qui l'englobe.

4. Composant piézoélectrique multicouche (1) selon l'une des revendications précédentes, dans lequel la couche d'électrode (3a, 3b) joue le rôle d'un emplacement de rupture préférentielle en cas de sollicitations mécaniques.

5. Composant piézoélectrique multicouche selon l'une des revendications précédentes, dans lequel une fissure qui s'étend de manière contrôlée essentiellement parallèlement à la couche d'électrode se propage dans la couche d'électrode (3a, 3b) sous l'effet d'une sollicitation mécanique.

6. Composant piézoélectrique multicouche selon l'une des revendications 2 à 5, dans lequel le matériau céramique que contient la couche d'électrode (3a, 3b) est différent du matériau céramique des couches céramiques (2) qui l'englobent.

7. Composant piézoélectrique multicouche selon l'une des revendications précédentes, dans lequel la couche d'électrode (3a, 3b) contient un matériau céramique constitué d'un mélange d'oxyde de zirconium et d'oxyde de titane.

8. Composant piézoélectrique multicouche selon l'une des revendications précédentes, dans lequel la couche d'électrode (3a, 3b) contient au moins un métal sélectionné parmi le palladium, l'argent et le cuivre.

9. Composant piézoélectrique multicouche (1) selon l'une des revendications précédentes, dans lequel les couches céramiques (2) contiennent un mélange de plomb, de zirconate et de titanate.

10. Composant piézoélectrique multicouche (1) selon l'une des revendications précédentes, dans lequel la différence entre la taille des grains céramiques grossiers et celle des grains céramiques fins est un multiple de cette dernière.

11. Composant piézoélectrique multicouche (1) selon l'une des revendications précédentes, dans lequel la répartition des couches d'électrode (3a, 3b) comprend des intervalles réguliers, les différentes distances étant formées par plusieurs couches céramiques (2).

12. Composant piézoélectrique multicouche (1) selon l'une des revendications précédentes, dans lequel au moins une couche d'électrode (3a, 3b) contient un matériau céramique qui modifie suffisamment sa densité par rapport à la céramique qui l'englobe pour que les ondes de pression qui agissent sur le composant multicouche soient absorbées, rompues, déviées ou détruites.

13. Composant piézoélectrique multicouche selon l'une des revendications précédentes, dans lequel au moins une couche d'électrode (3a, 3b) contient un matériau céramique qui modifie suffisamment la compressibilité par rapport à celle de la céramique qu'il englobe pour que les ondes de pression qui agissent sur le composant multicouche soient absorbées, rompues, déviées ou détruites.

14. Composant piézoélectrique multicouche (1) selon l'une des revendications précédentes, dans lequel les couches d'électrode (3a, 3b) sont empilées en alternance et sont mises en contact avec différents raccordements extérieurs (5).

15. Composant piézoélectrique multicouche (1) selon l'une des revendications précédentes, présentant plusieurs couches céramiques (2) et plusieurs couches d'électrode (3a, 3b), le matériau d'au moins une couche d'électrode présentant un réseau différent de celui des couches céramiques et qui freine au moins en partie la propagation dans le sens de la longueur d'ondes de pression qui agissent sur le composant multicouche, la ou les couches d'électrode contenant un mélange de grains céramiques grossiers (4a) et de grains céramiques fins (4b) dans une répartition granulométrique bimodale.
